# EUROPEAN PATENT APPLICATION

(11) **EP 2 592 531 A2**
(43) Date of publication of application: **15.05.2013**
(21) Application number: 12190559.0
(22) Date of filing: 30.10.2012
(51) Int. Cl.: G06F 3/02

(54) **Electronic device and display device**

(30) Priority: 10.11.2011 JP 2011246582; 31.08.2012 JP 2012191666
(71) Applicant: Funai Electric Co., Ltd., Daito-shi, Osaka 574-0013 (JP)
(72) Inventor: MIYAJIMA, Kazutoshi, Daito-shi, Osaka 574-0013 (JP)
(74) Representative: Grünecker, Kinkeldey, Stockmair & Schwanhäusser

(57) **Abstract**

The present invention discloses an electronic device having a first control section that outputs a predetermined signal to one of plurality of first lines according to the instructions input from operation keys, an output signal setting section that is connected to the first control section via the first lines to specify a voltage value based on the signal input from the first lines, and a second control section that identifies a predetermined process corresponding to the instruction received by the first control section based on the voltage value specified by the output signal setting section and then executes the process.

## Description

### BACKGROUND OF THE INVENTION

### 1. Field of the Invention:

The present invention is related to an electronic device and a display device having an operation receiving section to receive predetermined instructions.

### 2. Description of the Related Art:

An electronic device having operation keys (operation receiving section) to receive instructions is known in the prior art. For example, user's instructions are received through the operation keys such as touch keys located on the front side of the electronic device.

As shown in Japanese Patent Application Publication No. 07-005987, Japanese Patent Application Publication No. 2004-234263, and Japanese Utility Patent Application Publication No. 58-122138, in order to mount the operation keys on the electronic device, the electronic device should include a first circuit that outputs a signal according to the instruction received from the operation keys and a second circuit that identifies or executes a predetermined process. In addition, the first circuit and the second circuit are connected via a serial bus such as an I2C (Inter-Integrated Circuit) bus in order to establish communication between the first circuit and the second circuit.

If the serial bus is used, an internal structure of the first circuit should be configured for exclusive use because the first circuit is connected to plural lines at an input side while it is connected to the second circuit by one line at an output side. In addition, an internal structure of the second circuit should be also configured for exclusive use because the second circuit identifies plural processes based on a digital signal that is input from the one line. If the first circuit is changed because of the design change or the like, the second circuit should be newly designed in the prior art. In other words, it is difficult to use the second circuit without changing the configuration.

### BRIEF SUMMARY OF THE INVENTION

It is an object of the invention to provide an electronic device or a display device in which circuits can be connected together without using the serial bus.
In addition, the present invention provides an electronic device or a display device that can be flexibly configured even when design changes occur.

In one aspect of the present invention, an electronic device has a first control section that outputs a first signal to one of plurality of first lines according to the instructions input from operation keys, an output signal setting section that is connected to the first control section via the first lines to specify a voltage value based on the first signal input from the first lines, and a second control section that identifies a predetermined process corresponding to the instruction received by the first control section based on the voltage value specified by the output signal setting section and then executes the process.

In the above described configuration, the first control section outputs the first signal to the first lines according to the instructions input from the operation keys, and the first control section is connected to the output signal setting section via the first lines. In addition, the output signal setting section specifies the voltage value based on the first signal input from the first lines. Therefore, the second control section connected to the output signal setting section identifies the process corresponding to the instruction received by the first control section based on the voltage value specified by the output signal setting section and then executes the process. In other words, the first control section can be connected to the second control section without using the serial bus by placing the output signal setting section between the first control section and the second control section.

In another aspect of the present invention, the first control section has an operation receiving section that is connected to second lines to output a second signal to the second lines according to the instruction input from the operation keys, and an IC that is connected to the operation receiving section via the second lines to switch whether or not to output the first signal to each of the first lines depending on which of the second lines outputs the second signal.
In the above described configuration, the first control section can be easily replaced with a circuit having an operation receiving section that is mechanically deformed at its contact points because the signals based on the instruction are output in parallel.

In another aspect of the present invention, the IC outputs the first signal by establishing an electrical connection with each of the first lines depending on which of the second lines outputs the second signal.
In the above described configuration, the present invention can be achieved by control blocks mounted on conventional IC.

In another aspect of the present invention, the operation receiving section has touch keys.
In the above described configuration, the touch keys can be connected without using the serial bus even if the touch keys are used for the operation receiving section of the electronic device.

In another aspect of the present invention, the output signal setting section is composed of a series circuit formed by resistors connected in series, the first lines are connected to each connection point of the resistors, a predetermined DC voltage is supplied to the output signal setting section, and the voltage value output from the output signal setting section is specified based on a resistance value of the series circuit that is changed depending on the first signal output from the first lines.
In the above described configuration, the function of the output signal setting section can be achieved with a simple configuration.

### BRIEF DESCRIPTION OF THE DRAWINGS

The following detailed description, given by way of example and not intended to limit the present invention solely thereto, will best be appreciated in conjunction with the accompanying drawings, wherein like reference numerals denote like elements and parts, in which:
Fig. 1 is a perspective view of an electronic device 1.
Fig. 2 is a block diagram to explain a configuration of the electronic device 1.
Fig. 3 explains functions of an input IC 12.
Fig. 4 is a flow chart showing a process executed by a system microcomputer 30.
Fig. 5 explains functions of the electronic device 1.
Fig. 6 explains functions of a touch key module 10.

### DETAILED DESCRIPTION OF THE INVENTION

Hereinafter, embodiments of the present invention will be explained in the following order.
1. First embodiment:
2. Second embodiment:
3. Other embodiments:

### 1. First embodiment

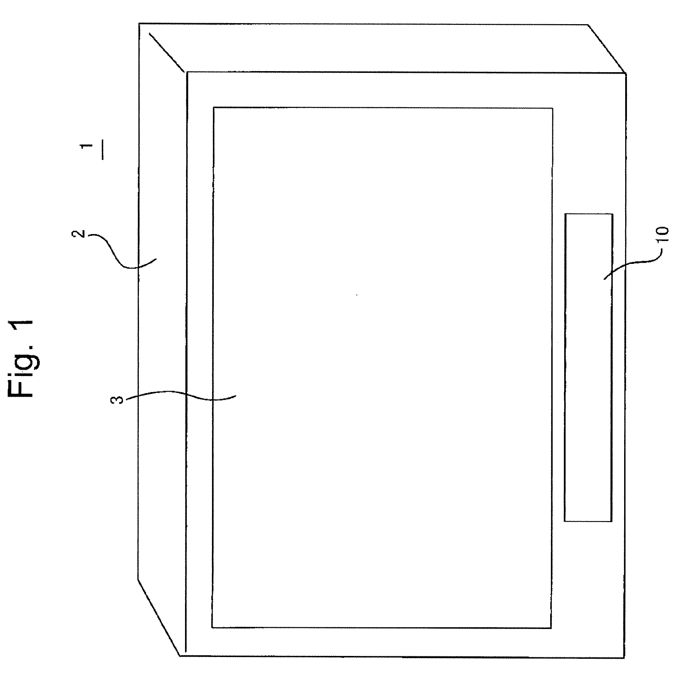

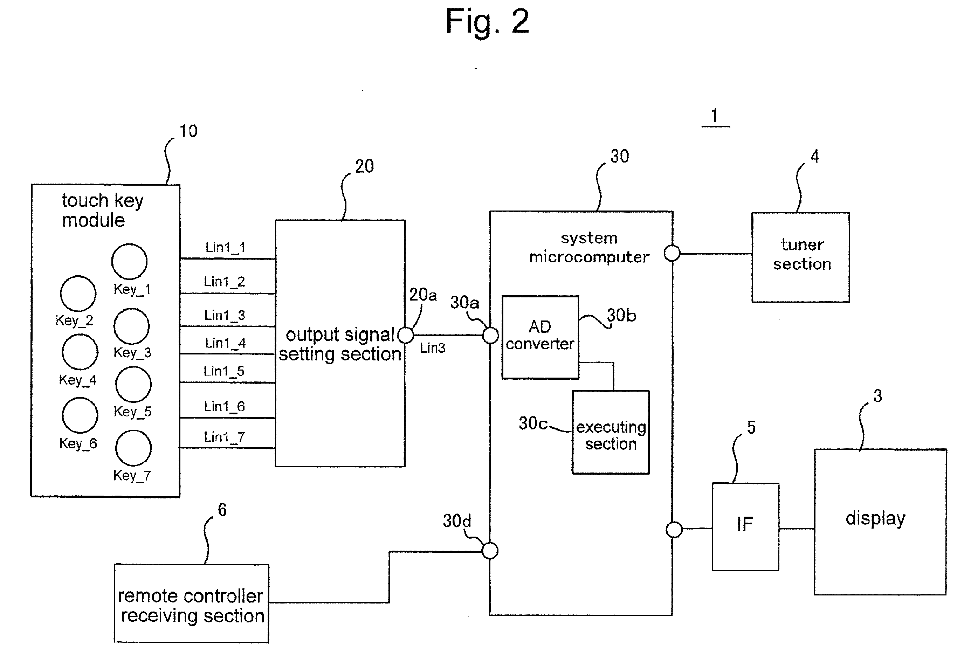

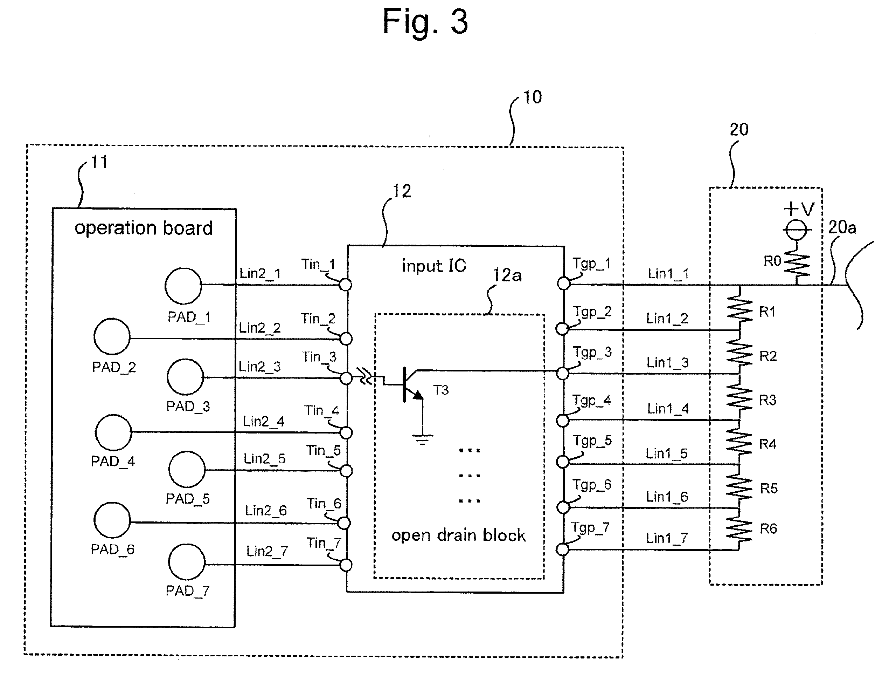

A first embodiment to realize an electronic device of the present invention will be explained below with reference to drawings. Fig. 1 is a perspective view of an electronic device 1. Fig. 2 is a block diagram to explain a configuration of the electronic device 1. Fig. 3 explains functions of an input IC 12.

An electronic device 1 shown in Fig. 1 has a function of a television receiver (display device). Therefore, a display 3 is exposed on the front side of a cabinet 2 in order to display images. In addition, touch keys are located below the display 3 on the front side of the cabinet 2 in order to receive an instruction from a user. The touch keys are a part of a touch key module 10. The user usually operates the electronic device 1 by using a remote controller, but the users can also operate the electronic device 1 by using the touch keys.

As shown in Fig. 2, the electronic device 1 has, in the cabinet 2, a display 3, a tuner section 4, a touch key module (first control section) 10, an output signal setting section 20, a system microcomputer (second control section) 30, an IF (Interface) 5, and a remote control receiving section 6. As explained later, each section described above is connected to the system microcomputer 30 via a bus or a line to be comprehensively controlled by the system microcomputer 30.

As shown in Fig. 2, touch keys Key_n are aligned on the touch key module 10 in order to receive the instruction from a user or the like, wherein n is an integer from 1 to 7. The touch key module 10 is composed of a circuit board on which plural circuits are mounted. As shown in Fig. 3, the circuit board has an operation board (operation receiving section) 11 that receives the instruction and an input IC 12 that outputs a predetermined signal based on the received instruction.

In the present embodiment, the touch key Key_1 corresponds to a process of "channel up", and the touch key Key_2 corresponds to a process of "channel down". Namely, the system microcomputer 3 change channels on the tuner section 4 in ascending order if the touch key Key_1 is touched by the user, while the system microcomputer 3 changes the channels in descending order if the touch key Key_2 is touched by the user. The touch key Key_3 corresponds to a process of "volume up", and the touch key Key_4 corresponds to a process of "volume down". Namely, the system microcomputer 3 turns up speaker volume if the touch key Key_3 is touched by the user, while the system microcomputer 3 turns down the speaker volume if the touch key Key_4 is touched by the user (although the speaker is not illustrated). The touch key Key_5 corresponds to a process of "menu screen switching", the touch key Key_6 corresponds to a process of "external input switching", and the touch key Key_7 corresponds to a process of "main power ON/OFF".

The operation board 11 of the touch key module 10 has a glass substrate (not illustrated) and capacitance detection sensors PAD_n that are placed on predetermined positions corresponding to each of the touch keys Key_n (Fig. 3). The capacitance detection sensors PAD_n are connected to the respective second lines Lin2_n. When one of the capacitance detection sensors PAD_n detects touch operation applied by the user or the like, a signal of high level is output through one of the second lines Lin2_n connected to the capacitance detection sensor PAD_n that detects the touch operation.

Opposite ends of the second lines Lin2_n are connected to the respective input terminals Tin_n of the input IC 12. GPIO terminals Tgp_n of the input IC 12 are connected to the respective first lines Lin1_n. The input IC 12 includes functional blocks such as an open drain block 12a. The open drain block 12a switches level (high or low) of the signal output to the GPIO terminals Tgp_n based on the signal input from the input terminals Tin_n.

The open drain block 12a included in the input IC 12 has a function to switch whether or not to output the signal to the respective GPIO terminals Tgp_n based on the signal input from the input terminals Tin_n. More specifically, the open drain block 12a functions as a transistor. For example, collectors of transistors T_n are connected to the respective GPIO terminals Tgp_n, bases are connected to the respective input terminals Tin_n, and emitters are connected to the ground. Note that only one functional block included in the open drain block 12a to connect the input terminal Tin_3 to the GPIO terminal Tgp_3 is shown in Fig. 3, but functional blocks also exist on other terminals in the same manner. If the signal input from the input terminal Tin_3 is low level, for example, the transistor T3 is turned off and consequently both the GPIO terminal Tgp_3 connected to the transistor T3 and the first line Lin1_3 connected to the GPIO terminal Tgp_3 are switched to open (high impedance). On the other hand, if the signals input from the input terminals Tin_n are high level, the respective transistors Tn are turned on and consequently the respective GPIO terminals Tgp_n are switched to low level.

Opposite ends of the first lines Lin1_n, which are not connected to the input IC 12, are connected to the output signal setting section 20. The output signal setting section 20 is a circuit to specify a voltage value based on the presence or absence of the signals output from the first lines Lin1_n. Specifically, as shown in Fig. 3, the output signal setting section 20 is composed of a ladder resistor (series circuit) formed by a resistor R0 and N-1 resistors Rn'. In the present embodiment, N is 7 and n' is an integer from 1 to 6. The first line Lin1_1 is connected one end of the resistor R1 that forms the ladder resistor, while another end of the resistor R1 is connected to the resistor R2. The first lines Lin1_2 to Lin1_6 are connected to the respective connection points between the resistors R1 to R6. The first line Lin1_7 is connected one end of the resistor R6, while another end of the resistor R6 is connected to the resistor R5. The output signal setting section 20 is connected to a power circuit (not illustrated) to supply DC voltage. Therefore, a resistance value of the ladder resistor changes depending on which of the GPIO terminals Tgp_n outputs the signal of low level. Consequently, seven levels of voltage can be generated at an output terminal 20a.

As an example, the resistance values of each of the resistors that form the ladder resistor can be specified as follows: resistor R0: 10k ohm, resistor R1: 2.2k ohm, resistor R2: 2.2k ohm, resistor R3: 2.7k ohm, resistor R4: 4.7k ohm, resistor R5: 8.2k ohm, and resistor R6: 18k ohm. Of course, the resistance values can be set arbitrarily without being limited to the above values.

As shown in Fig. 2, the output terminal 20a of the output signal setting section 20 is connected to a Key-IN terminal 30a of the system microcomputer 30 via a third line Lin3. The system microcomputer 30 includes an AD converter 30b and an executing section 30c. An input side of the AD converter 30b is connected to the Key-IN terminal 30a. The AD converter 30b outputs a digital signal based on the seven levels of the voltage generated at the Key-IN terminal 30a. The executing section 30c is connected to an output side of the AD converter 30b. Based on the digital signal output from the AD converter 30b, the executing section 30c identifies a process to be executed and then executes the process. In the present embodiment, the process is one of the following: "channel up", "channel down", "volume up", "volume down", "menu screen switching", "external input switching", or "main power ON/OFF".

In the present embodiment, the executing section 30c is achieved by executing a program recorded in the system microcomputer 30. However, the executing section 30c can also be achieved with other configurations. A remote control receiving terminal 30d of the system microcomputer 30 is connected to an output terminal of the remote control receiving section 6 via a line. Therefore, the instruction input from the remote controller is transferred to the system microcomputer 30 via the remote control receiving section 6.

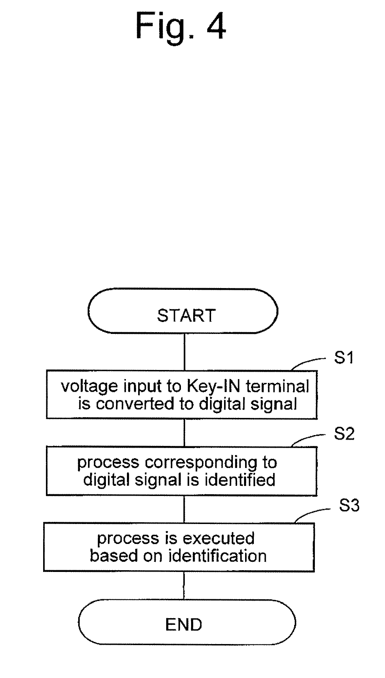

Fig. 4 is a flow chart showing a process executed by the system microcomputer 30. The process of how the system microcomputer 30 identifies the signal output from the touch key module 10 will be explained below with reference to Fig. 4.

If the user operates the touch key Key_2, for example, the operation is detected via the second line Lin2_2, and then the first line Lin1_2 is switched to low level by a function of the functional blocks included in the input IC 12. Therefore, the connection point between the resistors R1 and R2 of the output signal setting section 20 is switched to low level, and a predetermined voltage is generated at the third line Lin3 as a result of the change of the resistance value.

In step S1, the AD converter 30b converts the voltage generated at the Key-IN terminal 30a to the digital signal. As explained above, the voltage of the output signal setting section 20 is changed depending on the GPIO terminal Tgp_n where the signal level is switched, and the AD converter 30b generates the digital signal corresponding to the voltage value generated at the Key-IN terminal 30a to output the digital signal to the executing section 30c.

In step S2, the executing section 30c identifies a process corresponding to the digital signal output from the AD converter 30b. The executing section 30c preliminarily records a correspondence between values of the digital signals and the processes to be executed as a table. For example, the processes to be executed are "channel up", "channel down", "volume up", "volume down", "menu screen switching", "external input switching", and "main power ON/OFF". Once the digital signal is input from the AD converter 30b, the executing section 30c identifies the process with reference to the correspondence. In case the digital signal corresponding to the touch key Key_2 is output from the AD converter 30b, the executing section 30c identifies the process corresponding to the digital signal as "channel down" with reference to the correspondence.

In step S3, the process is executed based on the identification in Step S2. In other words, the executing section 30c executes one of the following processes: "channel up", "channel down", "volume up", "volume down", "menu screen switching", "external input switching", or "main power ON/OFF". For example, if the executing section 30c identifies the process corresponding to the digital signal input to the Key-IN terminal 30a as "channel down", the executing section 30c outputs predetermined signals from the respective output terminals to change the channel on the tuner section 4.

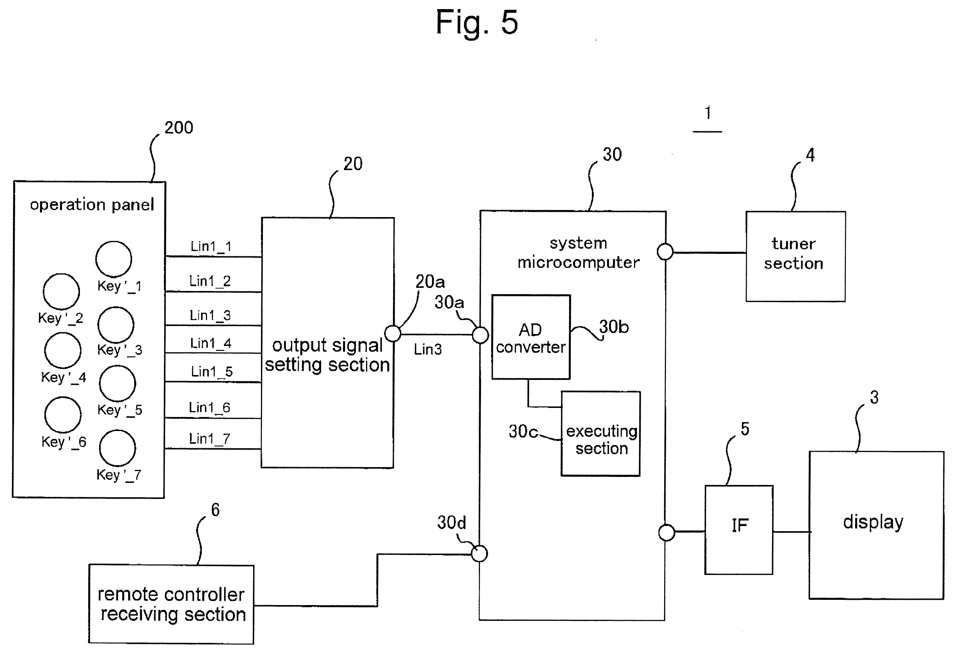

Effect of the present embodiment will be explained below by using an example of the electronic device 1 in which the touch key module 10 is replaced with an operation panel 200. Fig. 5 shows a case when a mechanical operation panel is connected to the electronic device 1. In the operation panel 200, the first lines Lin1_n are connected to operation keys Key'_n. In the present embodiment, n is an integer from 1 to 7. According to an operation (pressing force) of each of the operation keys Key'_n, the corresponding first lines Lin1_n is switched to open or low level.

In case the mechanical operation panel 200 is used as the operation receiving section, as shown in Fig. 5, the operation panel 200 is connected to the system microcomputer 30 via the output signal setting section 20. Specifically, the first lines Lin1_n connected to the operation keys Key'_n of the operation panel 200 are also connected to the respective connection points of the resistors Rn' of the output signal setting section 20.

If one of the operation keys Key'_n of the operation panel 200 is operated (pressed), a signal is input to the corresponding first line Lin1_n. Therefore, the resistance value of the output signal setting section 20 is changed, and a voltage corresponding to the operated operation key Key'_n is generated at the output terminal 20a and then at the third line Lin3. Consequently, the system microcomputer 30 can control a subsequent circuit based on the voltage generated at the Key-IN terminal 30a. In other words, the system microcomputer 30 can identify the process corresponding to the instruction by using the same input format as when the touch key module 10 is connected.

As explained above, the present invention enables the first control section (touch key module 10) and the second control section (system microcomputer 30) to be connected together without using the serial bus. Consequently, the product can be flexibly configured even when design changes occur.
If the serial bus is used, both of the first circuit and the second circuit should be configured for exclusive use. In the present invention, on the other hand, the second control circuit can be used without changing the configuration even when the first control circuit is changed as a result of the design change or the like because the first control circuit and the second control circuit can be connected together without using the serial bus.

In addition, the terminals of the system microcomputer 30 can be reduced because the signals based on various instructions can be received from one line.

The touch key module 10 can be easily replaced by any circuits as long as the circuit has an operation receiving section that is mechanically deformed at its contact points if the touch key module 10 is specified to output the signals in parallel based on the instruction.
The present invention can be achieved by control blocks mounted on a conventional IC if a circuit of the input IC 12 included in the touch key module 10 is configured by using the open drain block.

Even if the touch keys are used for the operation receiving section of the electronic device, the touch keys can be connected without using the serial bus if the touch key module is specified as the first control section.

The function of the output signal setting section 20 can be achieved with a simple configuration if the ladder resistor (series circuit) formed by plural resistors connected in series is used.

### 2. Second embodiment

Next, the second embodiment of the electronic device 1 will be explained.

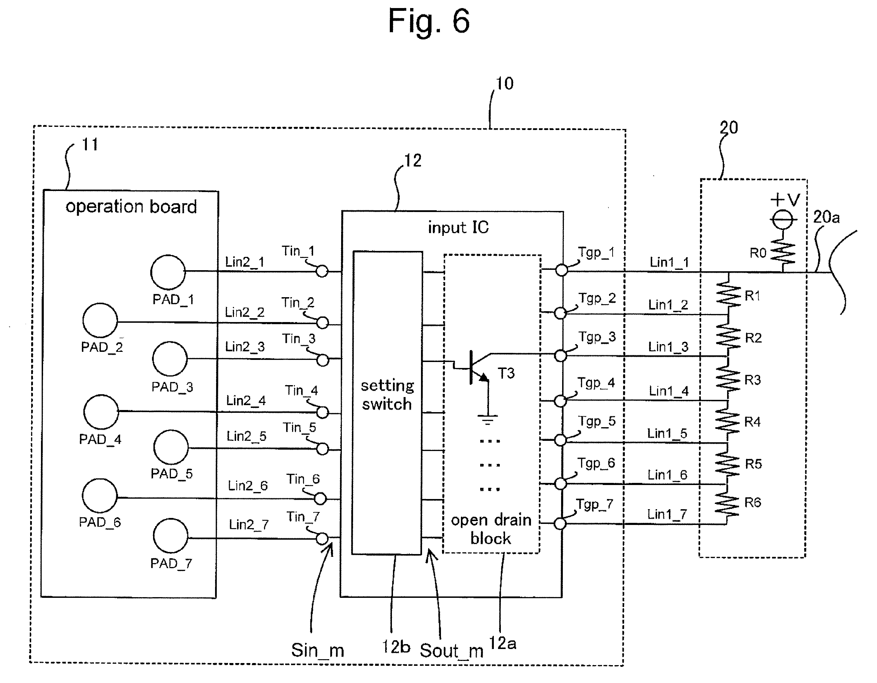

Fig. 6 explains functions of the touch key module 10 concerning the second embodiment.

In the second embodiment, unlike the first embodiment, a correspondence between the touch keys Key_n and the GPIO terminals Tgp_n whose signal levels are changed by the operation of the respective touch keys Key_n can be specified in the input IC 12 without depending on the actual position of the touch keys Key_n aligned on the operation board 11. If the design change is required, the processes assigned to the touch keys Key_n can be easily changed by changing the setting of the input IC 12.

As shown in Fig. 6, same as the first embodiment, an output side of the touch key module 10 is connected to the output signal setting section 20 via the first lines Lin1_n. Same as the first embodiment, the output signal setting section 20 is connected to the system microcomputer 30 via the third line Lin3 (Fig. 2).

Same as the first embodiment, the touch key module 10 has the operation board 11 and the input IC 12. Same as the first embodiment, the capacitance detection sensors PAD_n of the operation board 11 are connected to the respective input terminals Tin_n of the input IC 12 via the second lines Lin2_n. Same as the first embodiment, the GPIO terminals Tgp_n of the input IC 12 are connected to the respective connection points between the resistors Rn of the output signal setting section 20 via the first lines Lin1_n.

The input IC 12 has a setting switch 12b in addition to the open drain block 12a. The setting switch 12b specifies which of the GPIO terminals Tgp_n will be turned on/off when the signal is input from each of the input terminals Tin_n. The setting switch 12b is connected to each of the input terminals Tin_n and to the open drain block 12a.

For example, input side terminals Sin_in of the setting switch 12b are connected to the respective input terminals Tin_n, and output side terminals Sout_m are connected to the respective gates of the transistor T_n, wherein m is same number as n. In the present embodiment, m is an integer from 1 to 7. When a signal is input to one of the terminals Sin_m, the setting switch 12b changes the voltage of one of the terminals Sout_m to high level according to the correspondence specified in the setting switch 12b.
In case the terminal Sin_2 is associated with the terminal Sout_3, when the high level signal is input to the terminal Sin_2 from the input terminal Tin_2, the setting switch 12b changes the voltage of the terminal Sout_3 to high level to turn on the transistor T3.

The setting switch 12b can be achieved by a program executed in the input IC 12. The setting switch 12b can also be achieved by mounting a circuit to switch the correspondence between the terminals Sin_m and the terminals Sout_m.

Same as the first embodiment, the executing section 30c of the system microcomputer 30 records the correspondence between the digital signals and the processes to be executed as the table. Same as the first embodiment, an example of the processes to be executed are "channel up", "channel down", "volume up", "volume down", "menu screen switching", "external input switching", and "main power ON/OFF".
The system microcomputer 30 records a program to change the table. By executing the program, the system microcomputer 30 receives an instruction to change the table from a worker via the remote control receiving section 6 or the like. Then, the system microcomputer 30 changes the table according to the received instruction.

As an example, it will be explained below how to change the processes associated with the touch keys Key_n in case the touch key module 10 is replaced in the above configured electronic device 1.
At first, the worker adjusts the setting switch 12b based on an alignment of the touch keys Key_n. In other words, the setting switch 12b is adjusted to specify the voltage values generated at the output signal setting section 20 when each of the touch keys Key_n (capacitance detection sensors PAD_n) is operated. Then, the worker changes the table recorded in the executing section 30c based on the correspondence between the specified touch keys Key_n and the voltage values generated at the output signal setting section 20. By changing the table, the system microcomputer 30 can identify the processes even when the processes corresponding to the voltage generated at the third line Lin3 are changed because of the design change.

As explained above, in addition to the effect of the first embodiment, the processes to associate with touch keys Key_n can be changed in the second embodiment. In other words, the design change of the electronic device 1 can be flexibly handled.

### 3. Other embodiments

Various embodiments can be employed in the present invention.
An internal configuration of the touch key module 10 is not limited to the configuration described in the first embodiment. In other words, the internal configuration of the touch key module 10 can be freely selected as long as the touch key module 10 is connected to the output signal setting section 20 via a plurality of lines. The first lines Lin1_n are not necessary to correspond one-to-one with the second lines Lin2_n.

To use the ladder resistor to form the output signal setting section 20 is only an example. For example, the output signal setting section 20 can be formed by a predetermined IC connected to each of the first lines Lin1_n to output a predetermined voltage according to a combination of the first lines Lin1_n from which the signal is output.
The touch keys are not limited to the above mentioned capacitance detection type. For example, an electromagnetic induction type can be used.

Note that, this invention is not limited to the above-mentioned embodiments. Although it is to those skilled in the art, the following are disclosed as the one embodiment of this invention.
- Mutually substitutable members, configurations, etc. disclosed in the embodiment can be used with their combination altered appropriately.
- Although not disclosed in the embodiment, members, configurations, etc. that belong to the known technology and can be substituted with the members, the configurations, etc. disclosed in the embodiment can be appropriately substituted or are used by altering their combination.
- Although not disclosed in the embodiment, members, configurations, etc. that those skilled in the art can consider as substitutions of the members, the configurations, etc. disclosed in the embodiment are substituted with the above mentioned appropriately or are used by altering its combination.

## Claims

1. An electronic device having operation keys to receive predetermined instructions, comprising:
a first control section that outputs a first signal to one of plurality of first lines according to the instructions input from the operation keys;
an output signal setting section that is connected to the first control section via the first lines to specify a voltage value based on the first signal input from the first lines; and
a second control section that identifies a predetermined process corresponding to the instruction received by the first control section based on the voltage value specified by the output signal setting section and then executes the process.

2. The electronic device according to claim 1, wherein:
the first control section has;
an operation receiving section that is connected to second lines to output a second signal to the second lines according to the instruction input from the operation keys; and
an IC that is connected to the operation receiving section via the second lines to switch whether or not to output the first signal to each of the first lines depending on which of the second lines outputs the second signal.

3. The electronic device according to claim 2, wherein:
the IC outputs the first signal by establishing an electrical connection with each of the first lines depending on which of the second lines outputs the second signal.

4. The electronic device according to claims 2 or 3, wherein:
the operation receiving section has touch keys.

5. The electronic device according to any one of claims 1 to 4, wherein:
the output signal setting section is composed of a series circuit formed by resistors connected in series,
the first lines are connected to each connection point of the resistors,
a predetermined DC voltage is supplied to the output signal setting section, and
the voltage value output from the output signal setting section is specified based on a resistance value of the series circuit that is changed depending on the signal output from the first lines.

6. A display device having operation keys to receive predetermined instructions, comprising:
a first control section that outputs a first signal to one of plurality of first lines according to the instructions input from the operation keys;
an output signal setting section that is connected to the first control section via the first lines to specify a voltage value based on the first signal input from the first lines; and
a second control section that identifies a predetermined process corresponding to the instruction received by the first control section based on the voltage value specified by the output signal setting section and then executes the process.
